# EUROPEAN PATENT SPECIFICATION

(11) **EP 1 967 861 B1**
(45) Date of publication and mention of the grant of the patent: **27.03.2019**
(21) Application number: 07123635.0
(22) Date of filing: 19.12.2007
(51) Int. Cl.: G01R 19/00, B60L 11/18, H02J 13/00, G01R 31/36

(54) **Voltage Monitor Circuit**
Spannungswächterschaltung
Circuit de surveillance de tension

(30) Priority: 19.12.2006 JP 2006340878
(43) Date of publication of application: 10.09.2008
(73) Proprietor: HONDA MOTOR CO., LTD., Tokyo (JP)
(72) Inventor: Ohnuki, Yasumichi, Saitama 351-0193 (JP)
(74) Representative: Rupp, Christian

(56) References cited:
- EP-A- 1 763 119
- JP-A- 2001 208 782
- US-A- 4 719 401
- US-A- 5 705 929
- US-A- 5 773 959
- US-A1- 2005 206 386
- US-A1- 2006 012 336

## Description

### Background of the Invention

### Field of the Invention

The present invention relates to a voltage monitor circuit which monitors a voltage of a storage unit, wherein capacitors are connected in series.

### Description of the Related Art

In a hybrid vehicle and the like, a great number of batteries are connected in series as a battery pack and stored in a battery box. The battery pack generates a high voltage and an inverter used for driving a motor is operated by a direct current. A voltage of each battery is always monitored by a monitor circuit. Further, batteries in series are divided into about half segments where a current breaking switch and a fuse are interposed in a series circuit. For the purpose of maintenance, a lock mechanism is provided to prevent the battery box from opening unless the current breaking switch is turned off. Incidentally, in the hybrid vehicle and the like, an intermediate part of batteries connected in series is divided into circuits by the current breaking switch or the like to generate a voltage lower than a voltage of a battery pack which is applied to an external terminal at a time of an inspection (for example, a voltage approximately half a voltage of the battery pack).

In a battery used for a battery pack, for example, when a gas is generated inside a battery and pressure inside the battery increases, a battery which is configured to cut off a current by separating an internal terminal of the battery from an external terminal of the battery is used (for example, refer to JP 2005-44523A) . A battery with a fuse, wherein a fuse is interposed in series for each battery, is used, respectively dealing to provide against an abnormal condition and an overcuurent. Further, a well-known monitor circuit is that a terminal of each battery connected in series and a monitor circuit are connected with many wires. A voltage of each battery is detected by a differential amplifier (operational amplifier) and always monitored (for example, JP 2005-292137A). In this case, when a current breaking switch is connected in series at a place where a plurality of batteries are divided and the current breaking switch is turned on, a voltage across terminals of each battery is input for the monitor circuit to detect a voltage of each battery.

However, when the current breaking switch connected in series with the battery positioned at a halfway point of the battery pack is turned off, a voltage with a value which subtracts a voltage of a battery connected with the current breaking switch from a voltage of the battery pack is applied with reversed polarity between adjoining input terminals of monitor circuits connected with wiring for voltage detection therebetween the current breaking switch is sandwitched.

When overvoltage occurs in a hybrid vehicle having a number of battery packs in series, a voltage detection element like an operational amplifier whose resisting pressure is generally not high, as low as 50V, may be damaged by the overvoltage and print wiring of a monitor circuit may burn. Further, as shown in JP 2005-292137A, a flying capacitor is installed at an input side of a voltage monitor circuit included in a monitor circuit in order to stabilize a detected voltage by suppressing an excessive fluctuation in a voltage of the battery and noise. When a high voltage with reversed polarity is generated at a time of turning off the current breaking switch as described above, the flying capacitor is short-circuited and damaged. Consequently, a short-circuit current flows through the monitor circuit and is likely to cause secondary damage and blow a fuse connected in series with the current breaking switch.

Subsequently, when a monitor circuit is divided in two to provide a high withstanding voltage between two monitor circuits by adding a wire for a voltage detection terminal of a battery so as to separately detect a voltage of the battery at both terminals of a current breaking switch, a high voltage with reversed polarity is not applied between input terminals of operational amplifiers when a current breaking switch is turned off. However the disposition intervals of operational amplifiers on a print circuit board need to be wider in order to secure a high withstanding voltage between the two monitor circuits. As a result, the monitor circuit inevitably gets bigger in size.

When a battery pack (storage unit) is made up of batteries in which internal terminals are separate from external terminals , as described in JP 2005-44523A , or the batteries each include a fuse, it is difficult to know at which battery (electric storage cell) a series circuit is cut off. Therefore, when a current breaking switch is turned off, a high voltage with reversed polarity is generated across the current breaking switch, it is necessary to provide a high withstanding voltage between the input terminals of every monitor circuit. As a result, a factor which is required to extend intervals between the input terminals and to install a protection circuit for a high voltage applied to an input terminal of an operational amplifier or the like makes a monitor circuit bigger in size and its price higher.

JP Patent Publication No. 2001208782 discloses that in order to prevent that a high voltage is applied to both ends of a changeover switch when a fuse is fused, the voltage is blocked with a diode for forbidding a sneak current. To this respect a positive pole potential of each of the battery modules wherein the lowest potential of battery blocks is set as reference is divided by a resistance type potential dividing circuit. Voltages of the low potential side resistance elements are detected with a module voltage detecting part while the lowest potential of the battery block is set as the reference. Difference of each of the detected potentials is outputted as a voltage of each of the battery modules.

US Patent Application Publication No. US 2006/0012336 A1 discloses a battery-pack voltage detection apparatus connected to a battery pack, the battery pack comprising N series connected battery modules, the N being an integer equal to or more than 2; and N+1 potential terminals corresponding to a highest potential, a lowest potential, and N-1 intermediate potentials of the N series battery modules, the battery-pack voltage detection apparatus comprising:
a voltage detection circuit connected to the N+1 potential terminals;
N+1 switches each having at least first, second, and third continuous semiconductor regions with alternating conductivity type, the N+1 switches being configured to individually open/close the connections of the N+1 potential terminals and the voltage detection circuit; and
N+1 driving units connected to at least one of the N+1 potential terminals and configured to apply at least one potential at at least one of the N+1 potential terminals to each of the N+1 switches to drive each of the N+1 switches.

### Brief Summary of the Invention

An object of the present invention is to provide a voltage monitor circuit which prevents an application of a high voltage for a monitor circuit even if a current breaking switch cuts off a series circuit of electric storage cells.

The present invention proposes a voltage monitoring circuit according to independent claim 1. Preferred embodiments of the invention are as outlined in the dependent claims 2 to 4.

Preferably, a voltage monitor circuit is connected in series with N sets of electric storage cells having optional sets
of electric storage elements, and applied to a storage unit in which a current breaking switch is interposed between, at least, a pair of adjacent electric storage cells. The voltage monitor circuit connected with (N+1) wires extended from each terminal of the N sets of electric storage cells comprises a monitor circuit which individually detects a voltage of the N sets of electric storage cells and a switch element which is interposed in series in the (N+1) wires, except for a wire with a maximum electric potential and a wire with a minimum electric potential, wherein the switch element is operated on a signal from the adjacent wire. The terms "switch element(s)" and "switching element(s)" are used herein as synonyms.

Under these configurations, in the a storage unit in which the N sets of electric storage cells are connected in series, a voltage with a value which adds up a total voltage of electric storage cells is generated across both terminals of the current breaking switch. In this time, as a polarity of any of wires connected with the current breaking switch is reversed, a switch element interposed in wires on the side of a lower electric potential than the electric potential of the current breaking switch or a switch element interposed in wires on the side of a higher electric potential than the electric potential of the current breaking switch changes into an OFF state. Therefore, as a high voltage generated across both terminals of the current breaking switch is distributed to all the switch elements which are turning off regarding this operation, the high voltage is not generated between the input terminals of the monitor circuit.
Incidentally, an electric storage includes a battery and a capacitor, in particular, regarding the battery, a storage unit can be a battery pack.

Preferably, the monitor circuit comprises a resistance element connected between the wires, wherein an electric resistance is connected at both terminals of the storage unit. When the current breaking switch is turned off, a wire with a maximum electric potential and a wire with a minimum electric potential are connected via the electric resistance. Consequently, a voltage with reversed polarity is generated across the current breaking switch. Similarly, as a resistance element is connected between wires of the monitor circuit, a potential difference between a wire connected with a switch element on the side of the monitor circuit and the adjacent wire lowers even if the current breaking switch is turned off. Further, as parasitic capacitance between wires is connected in parallel with a resistance element, a risk that the monitor circuit mistakenly detects a voltage due to noise or the like is reduced.

The invention according to claim 2 is the voltage monitor circuit described in independent claim 1, wherein each resistance element is connected in parallel with a diode with an anode on the side of a low electric potential and a cathode on the side of a high electric potential. Consequently, the switch element instantly changes into an OFF state even if there is parasitic capacitance between wires. Incidentally, when the diode is not connected, the
switch element changes into an OFF state in accordance with time constant which is determined by parasitic capacitance and a resistance value.

Preferably, the switch element is a solid state switch which turns on in response to a positive voltage. The solid state switches are interposed in the wires except for a wire with a maximum electric potential and are turned on in response to an electric potential on a wire adjoining on the side of a high electric potential.

Under these configurations, the solid state switch which is turned on when a positive voltage is applied is turned on in response to an electric potential of a wire adjoining on the side of a high electric potential. For example, if an N-channel MOSFET is used as a solid state switch, the N-channel MOSFET can be turned on in response to an electric voltage of a wire adjoining on the side of a high electric voltage. The current breaking switch connected in series between optional electric storage cells is turned off, the N-channel MOSFETs interposed in wires on the side of a lower electric potential than an electric potential of the current breaking switch are turned off. Therefore, as a high voltage generated across both terminals of the current breaking switch at a time of turning off the current breaking switch is distributed to all the N-channel MOSFETs, and a high voltage is not generated between input terminals of the monitor circuit.

The invention according to claim 4 is the voltage monitor
circuit described in claim 1 or 2. The switch element is a solid state switch which is turned on in response to a negative voltage. The solid state switches are interposed in series in the wires except for a wire with a minimum electric potential and turned on in response to an electric potential superimposed on a wire adjoining on the side of a low electric potential.

Under these configurations, the solid state switch which is turned on in response to a negative voltage is turned on in response to an electric potential of a wire adjoining on the side of a low electric potential. For example, if a P-channel MOSFET is used as a solid state switch, the P-channel MOSFET can be turned on in response to a signal from a wire adjoining on the side of a low electric potential. Therefore, the current breaking switch connected in series between optional electric storage cells is turned off, the P-channel MOSFETs interposed in wires on the side of a higher electric potential than an electric potential of the current breaking switch are turned off. As a high voltage generated across both terminals of the current breaking switch at a time of turning off the current breaking switch is distributed to all the P-channel MOSFETs which relevantly change into an OFF state, a risk that a high voltage is generated between input terminals of the monitor circuit is reduced.

According to the present invention, an application of a high voltage for a monitor circuit can be avoided even if a series circuit of an electric storage cell is cut off by a current breaking
switch.

### Brief Description of the Drawings

FIG. 1 is a circuit diagram showing a power supply circuit of a hybrid vehicle having a voltage monitor circuit according to embodiments of the present invention.
FIG. 2 is a circuit diagram showing a power supply circuit of a hybrid vehicle to realize the voltage monitor circuit of a first embodiment according to the present invention.
FIG.3A to 3D are shown waveforms of voltages at a point C', a point E', a point F', and a point G' of a wire for detecting a voltage in the power supply circuit shown in FIG.2.
FIG.4 is a circuit diagram showing the power supply circuit of the hybrid vehicle having a voltage monitor circuit of a second embodiment of the present invention.
FIG.5 is a circuit diagram showing the power supply circuit of the hybrid vehicle having a voltage monitor circuit of a third embodiment of the present invention.
FIG. 6 is a circuit diagram showing a power supply circuit including a conventional monitor circuit.
FIG.7 is a circuit diagram showing a conventional power supply circuit in which a monitor circuit is divided in two.
FIG.8 is a circuit diagram showing in which a fuse or an insulating switch for drive is interposed in each wire between a monitor circuit and each battery providing a battery pack.

### Detailed Description of the Preferred Embodiments

### [Power Supply Circuit for Hybrid Vehicle]

A power supply circuit for a hybrid vehicle including a voltage monitor circuit is exemplified to describe the present invention.

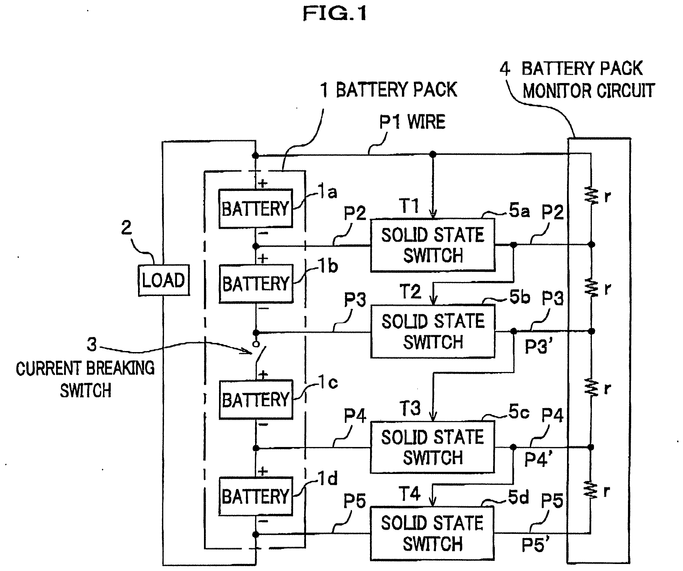

As shown in FIG. 1, this power supply circuit comprises a battery pack 1 which is a storage unit, wherein electric storages 1a, 1b, 1c, and 1d are connected in series. The power supply circuit further comprises a load 2 such as an inverter circuit or the like driven by the battery pack 1 of a high voltage as a power supply. The power supply circuit also comprises a current breaking switch 3 interposed between the battery 1b and the battery 1c, which are located at a halfway point of the battery pack 1, in order to change a voltage of the battery pack 1 into about a half voltage for a maintenance reason. The power supply circuit further comprises a battery pack monitor circuit 4 connected with terminals of each of batteries, 1a, 1b, 1c, and 1d via wires P1, P2, P3, P4, and P5, so as to monitor a voltage of each of batteries, 1a, 1b, 1c, and 1d, solid state switches 5a, 5b, 5c, and 5d, which are a switch element, connected in series with wires, P2, P3, P4, P5 except for the wire P1 with a maximum electric potential. Further, the solid state switches have gate terminals T1, T2, T3, and T4 which make ON/OFF control of each solid state switches 5a, 5b, 5c, and 5d are connected with wires adjoining on the side of a high electric potential and turned on with a signal from the wires. Incidentally, when batteries 1a, 1b, 1c, and 1d which are a capacitor is provided by a plurality of batteries, batteries 1a, 1b, 1c, and 1d are said in a different way as a electric storage cell.

Incidentally, in the power supply circuit, four sets of batteries, 1a, 1b, 1c, and 1d are connected in series. For example, when a battery pack of a high voltage such as 100V or 280V is connected, the connection of N sets of batteries in series serves as the battery pack of a high voltage. Then, the batteries 1a, 1b, 1c, and 1d can be made up of optional sets of batteries in series respectively as a cell. In this case, naturally, the battery pack monitor circuit 4 monitors a voltage per cell connected in series.

Next, an operation of the power supply circuit shown in FIG. 1 is explained. At a time of a normal operation, the current breaking switch 3 is turned on, and four sets of batteries, 1a, 1b, 1c, and 1d, connected in series provide the battery pack 1. The load 2 such as an inverter or the like is driven by supplying a high voltage, for example, 280V. The solid state switch 5a is turned on when a voltage from the wire P1 adjoining on the side of a high electric potential is applied as a control signal and the solid state switch 5b is turned on when a voltage from the wire P2 adjoining on the side of a high electric potential is applied. That is, all the solid state switches, 5a, 5b, 5c, and 5d are turned on in response to an electric potential of a wire adjoining on the side of a high electric potential. The battery pack 1 provides the load 2 with a series voltage which is the sum of batteries 1a, 1b, 1c, and 1d. The battery pack monitor circuit 4 detects and monitors an individual voltage of batteries 1a, 1b, 1c, and 1d.

If the current breaking switch 3 is turned off for a maintenance reason or the like, the load 2 makes equal the electric potential between a positive electrode of the battery 1a and a negative electrode of the battery 1b. For this reason, a series voltage with reversed polarity, which is the sum of the batteries 1a, 1b, 1c, and 1d, is generated across both terminals of the current breaking switch. Therefore, the wire P3 has a negative polarity, and a high voltage with a value which subtracts a voltage of the battery 1c from a series voltage of the battery pack 1 is generated between the wire P3 and P4 therebetween the current breaking switch 3 is sandwitched.

Because, the solid state switches 5a and 5b are kept being supplied with a positive voltage, the solid state switches 5a and 5b have been turned on. But the solid state switch 5c is turned off as the wire P3 has a negative voltage compared with the wire P4. Further, as wires P3' and P4' which are on the side of the battery pack monitor circuit 4 of the wires P3 and P4 are connected with a resistance element r with a low resistance value, the wire P4' also has a negative voltage. Consequently, the solid state switch 5d in which a voltage of the wire P4' is applied is also turned off.

Therefore, if the current breaking switch 3 is turned off, a high voltage is unlikely to be generated between the wire P3' and the wire P4' on the side of the battery pack monitor circuit 4. In other words, a high voltage with reversed polarity generated between the wires P3 and P4 on the side the battery pack 1 is distributed to the solid state switch 5c and the solid state switch 5d. As only a low voltage which is determined by an impedance of the resistance element in the battery pack monitor circuit 4 is applied between the wires P3' and P4' on the side of the battery pack monitor circuit 4, a risk of destroying a configuration element with a voltage in the battery pack monitor circuit 4 is reduced.

Incidentally, the number of current breaking switches 3 installed in a series circuit of batteries can be two or more in order to lower a generated voltage when the current breaking switches 3 are turned off.

### [First Embodiment]

A first embodiment is a concrete embodiment in which an N-channel MOSFET interposed in wires detecting a voltage of each battery constituting a battery pack is used as a two-way current-carrying solid state switch.

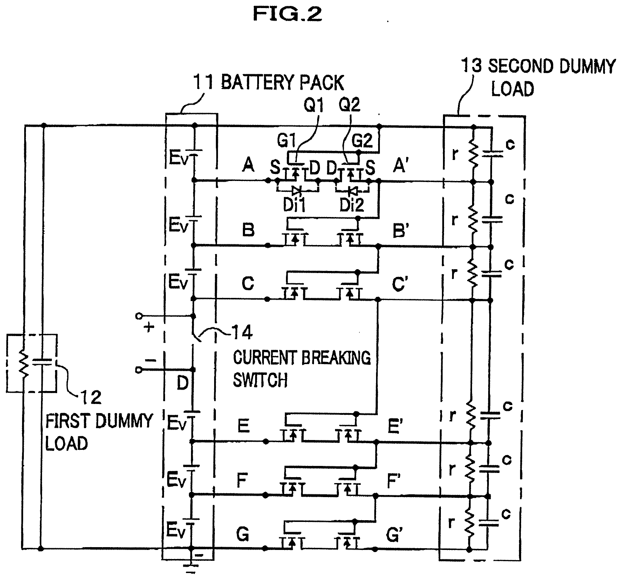

FIG. 2 is a circuit diagram showing a power supply circuit of a hybrid vehicle which includes a voltage monitor circuit of the first embodiment of the present invention. As shown in FIG.2, as for the power supply circuit of the first embodiment, an N-channel MOSFET is interposed between wires connecting each battery of a battery pack 11 with a monitor circuit (a second dummy load 13). Incidentally, In FIG.2, a drain terminal D, a source terminal S and gate terminals G1 and G2 of the N-channel MOSFET (hereinafter referred as a FET) are illustrated with a mark. Then, a pair of FETs from among FETs opposite to each other in series is marked with Q1 and Q2 for convenience sake. Further, each FET has a parasitic diode . To make a better understanding, only a diode Di1 and Di2 in a pair of FETs (Q1 and Q2) located on a wire route A-A' are illustrated as an equivalent circuit. That is, a pair of N-channel FETs (Q1 and Q2) opposite to each other connected in series serves as a two-way current-carrying solid state switch, wherein the parasitic diode Di1 and Di2 respectively operate.

In FIG. 2, a plurality of batteries Ev connected in series constitutes the battery pack 11. An intermediate part of the plurality of batteries Ev providing the battery pack 11 is connected in series with a current breaking switch 14. Further, the battery pack 11 is connected with an equivalent circuit of an inverter circuit as a first dummy load 12. As for a second dummy load 13 making up of an equivalent circuit of the monitor circuit, wires extended from terminals of each battery Ev providing the battery pack 11 are respectively connected with an impedance circuit which is a parallel circuit made up of a resistance element r and a capacitor c, and a voltage of each battery can individually be detected.

Under these configurations, a wire on the top of the figure is a wire with a maximum electric potential, an electric potential below the wire successively lowers wire by wire, a wire on the bottom of the figure is a wire with a minimum electric potential. In these configurations, two sets of N-channel FETs which is turned on with a positive voltage are connected opposite to each other in series in order to flow a current in both directions on each wire except for the wire with a maximum electric potential (that is, the wire on the top). Further, the gate terminals G1 and G2 of the N-channel FETs which are connected in series with each wire are connected in such a way that a control voltage is applied from a wire adjoining on the side of a high voltage.

Next, as an example, an operation of power supply circuit is explained as shown in FIG. 2 in which a voltage of each battery is 10V. When the current breaking switch 14 is closed, a gate voltage of 10V from the wire on the top is applied to the gate terminals G1 and G2 of the FETs (Q1 and Q2) interposed in the wire A-A' as a control voltage. Therefore, FETs (Q1 and Q2) interposed in the wire A-A' allow a current to flow in both directions in which a current flows from the wire A to the wire A' in a route of the parasitic diode Di1, the drain terminal D of the Q2, the source terminal S of the Q2, and a current flows from the wire A' to the wire A in a route of the parasitic diode Di2, the drain terminal D of the Q1, the source terminal S of the Q1.

A gate voltage of 10V from the wire A-A' is applied to gate terminals G1 and G2 interposed in a wire B-B'. Therefore, FETs interposed in the wire B-B' allow a current to flow in both directions. Consequently, all the FETs connected in series with a wire except for the wire on the top allow a current to flow in both directions in response to a gate voltage applied from a wire adjoining on the side of a high voltage. Consequently, a voltage of each battery Ev is applied to each impedance circuit (that is, CR parallel circuit) of the second dummy load 13 making up of an equivalent circuit of a monitor circuit, and an individual voltage is detected.

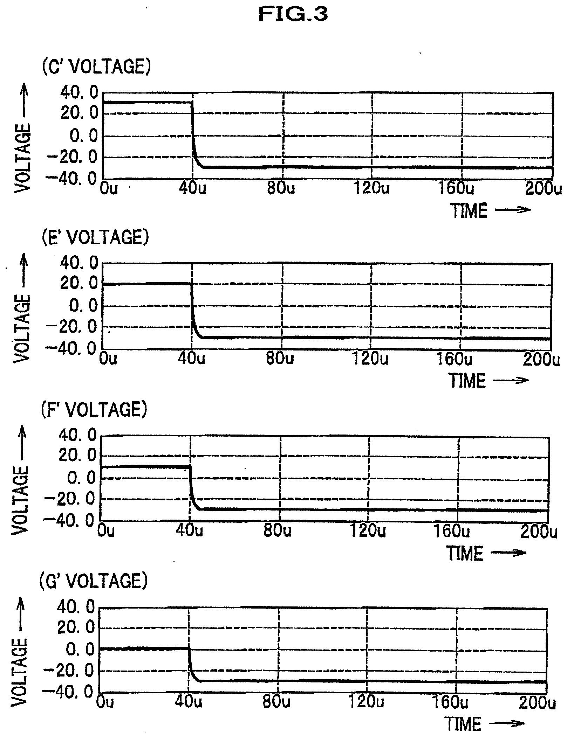

FIG. 3 is a waveform diagram for each voltage at a point C', E', F', and G' on wires used for detecting a voltage in the power supply circuit shown in FIG. 2. A horizontal axis indicates time and a vertical axis indicates voltage. In FIG. 2, each battery Ev is 10V. When all the FETs connected with every wire are turned on at a time of turning on the current breaking switch 14, as shown in FIG.3, a voltage at the point C' of a wire is 30V, a voltage at the point E' of a wire is 20V, a voltage at the point F' of a wire is 10V, and a voltage at the point G' of a wire is 0V, that is, a potential difference between adjacent wires is 10V. Therefore, a voltage of each wire (the C' point, the E' point, the F' point, the G' point) is applied to the gate terminals G1 and G2 of each FET adjoining on the side of a low electric potential and then each FET is turned on.

Next, when the current breaking switch 14 is turned off, each FET connected in series with the wire A-A', B-B', and C-C' remains to be turned on, and a FET interposed in a wire E-E' is turned off as an electric potential of the point C' becomes lower than an electric potential of the gate terminals G1 and G2 connected in series with the wire E-E'. Therefore, an impedance on the wire E-E' increases.

On the other hand, an impedance (CR parallel circuit) of the second dummy load 13 making up of an equivalent circuit of the monitor circuit is connected between the point C' and E' . In this time, a value of the resistance element r is significantly lower than an impedance of the wire E-E' at a time of turning off the FET connected in series with the wire E-E'. Therefore, the electric potential between the point C' and E' becomes equal. That is, an electric potential of the point E' is as low as an electric voltage of the point C'. Consequently, as the electric potential of the point E' is lower and a negative voltage is applied to gate terminals G1 and G2 of a FET connected in series with the wire E-E', a FET connected in series with a wire F-F' is turned off. Similarly, a FET connected in series with a wire G-G' is turned off.

Under these operations, when the current breaking switch 14 is turned off, each FET connected in series with the wire E-E' , F-F' , and G-G' on the side of a lower electric potential than that of the current breaking switch 14 is turned off and a minus 50 reverse voltage brought by turning off the current breaking switch 14 is distributed to each FET connected in series with the wire E-E', F-F', and G-G'. Consequently, a low voltage which is determined by a resistance value of the resistance element r is applied between terminals of each impedance circuit (CR parallel circuit) of the second dummy load 13 making up of an equivalent circuit of the monitor circuit.

### [Second Embodiment]

In the first embodiment, as for the second dummy load 13 making up of an equivalent circuit of the monitor circuit, each voltage detection circuit is a CR parallel circuit, so that a period of time during which the point C' has a negative voltage after turning off the current breaking switch 14 and an electric potential at each point E', F', and G' assumes an almost same negative electric potential as the point C' is delayed, depending on time constant of the CR parallel circuit. In a second embodiment, a voltage monitor circuit which takes this malfunction of time delay into consideration is suggested.

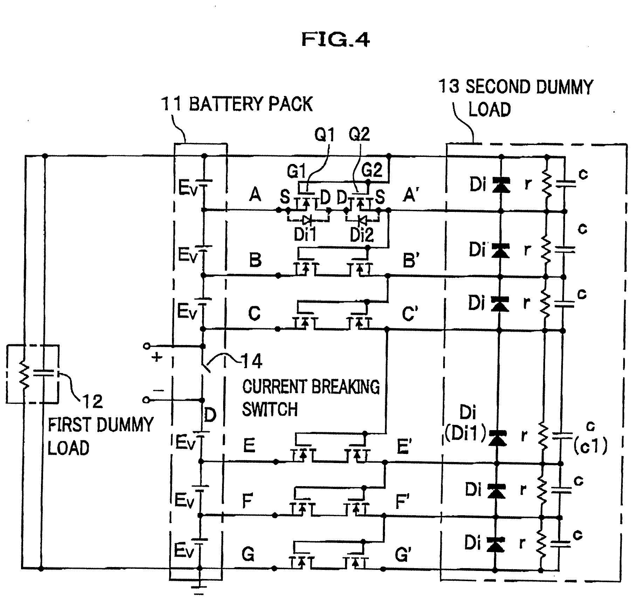

In a circuit diagram shown in FIG.4, a diode Di is connected in parallel with each CR parallel circuit of a second dummy load 13 making up of an equivalent circuit of the monitor circuit.

Consequently, as the diode Di is connected in parallel with CR parallel circuit, the wire C' has a negative voltage after turning off the current breaking switch 14. When FETs interposed in the wire E-E' are turned off and become a high impedance, a charge of a capacitor c (c1) is immediately released through the diode Di (Di1), and an electric potential of the point E' instantly assumes a same electric potential as the point C'.

Consequently, after turning off the current breaking switch 14, as a charge of the capacitor c of the CR parallel circuit is immediately released through the diode Di, a period of time during which the point C' has a negative voltage after turning off the current breaking switch 14 and an electric potential at each point E', F', and G' assumes a same negative electric potential as the point C' is a moment of time without depending on time constant of each CR parallel circuit of the second dummy load 13. Therefore, it is favorable to interpose the diode Di in parallel in the CR parallel circuit in order to instantly, securely lower an electric potential of a point E', F', and G' when each FET is turned off and becomes a high impedance.

### [Third Embodiment]

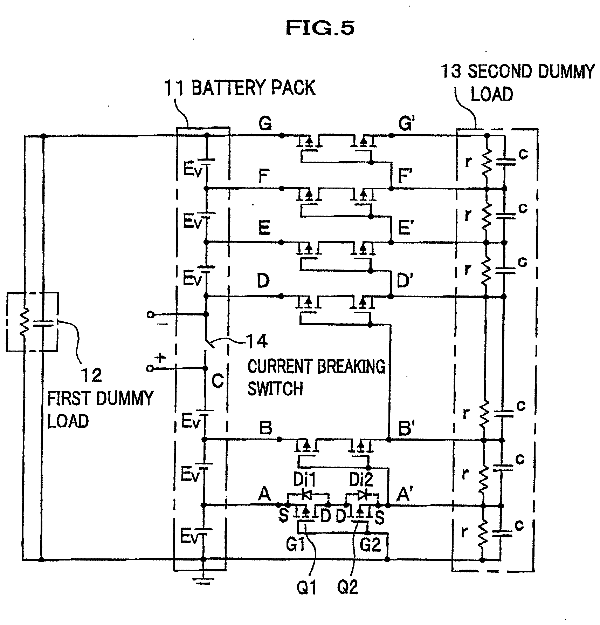

In a third embodiment, an embodiment in which a P-channel MOSFET (hereinafter referred as a FET) as a two-way current-carrying solid state switch interposed in a wire detecting a voltage of each battery making up of a battery pack is used is explained. FIG.5 is a circuit diagram showing a power supply circuit for a hybrid vehicle having a voltage monitor circuit in the third embodiment of the present invention. As shown in FIG.5, in the power supply circuit of the third embodiment, a P-channel FET which is turned on with a negative voltage on a gate terminal is used as a solid state switch interposed in a wire of the power supply circuit of the battery pack.

As shown in FIG. 5, when a P-channel FET is used, two sets of P-channel FETs are connected opposite to each other in series in order to flow a current in both directions with each wire except for a wire with a minimum electric potential (that is, the wire on the bottom of the figure). Further, the gate terminals G1 and G2 of the P-channel FETs which are connected in series with each wire are connected in such a way that a gate voltage is applied from a wire adjoining on the side of a low voltage.

Next, as an example, an operation of a power supply circuit is explained as shown in FIG. 5 in which a voltage of each battery is 10V. When the current breaking switch 14 is closed, a gate voltage of a minus 10V is applied to the gate terminals G1 and G2 of the FETs (Q1 and Q2) interposed in the wire A-A' from the wire on the lowest bottom. Therefore, the FETs (Q1 and Q2) interposed in the wire A-A' allow a current to flow in both directions in which a current flows from the wire A to the wire A' in a route of the source terminal S of the Q1, the drain terminal D of the Q1, the parasitic diode Di2 and a current flows from the wire A' to the wire A in a route of the source terminal S of the Q2, the drain terminal D of the Q2, and the parasitic diode Di1.

A gate voltage of a minus 10V is applied to gate terminals G1 and G2 interposed in the wire B-B' from the wire A-A'. Subsequently, FETs interposed in the wire B-B' allow a current to flow in both directions. Consequently, all the FETs connected in series with a wire except for the wire on the lowest bottom allow a current to flow in both directions in response to a negative gate voltage applied from a wire adjoining on the side of a low voltage. Therefore, a voltage of each battery Ev is applied to each impedance circuit (that is, CR parallel circuit) of the second dummy load 13 making up of an equivalent circuit of the monitor circuit, and an individual voltage is detected.

Next, when the current breaking switch 14 is turned off, each FET connected in series with the wire A-A' and B-B' remains to be turned on, however, at gate terminals G1 and G2 of FETs connected in series with the wire D-D', as an electric potential of the point C is as high as plus 50V, so an electric potential of the point B' increases. As a result, the FETs interposed in the wire D-D' are turned off. Consequently, an impedance on the wire D-D' increases.

On the other hand, a resistance element r of the second dummy load 13 making up of an equivalent circuit of the monitor circuit is connected between the point B' and the point D' . A value of this resistance element r is significantly smaller than an impedance on the wire D-D' when the FETs connected in series with the wire D-D' are turned off. Therefore, an electric potential between the point B' and D' nearly becomes equal, and an electric potential of the point D' is as high as that of the point B' . As the electric potential of the point D' lowers and a positive voltage is applied to the gate terminals G1 and G2 of FETs connected in series with the wire E-E', the FETs connected in series with the wire E-E' are also turned off. Similarly, each FET connected in series with the wire F-F' and G-G' is turned off.

Under these operations, all the FETs connected in series with the wire D-D', F-F' and G-G' on the side of a higher electric potential than that of the current breaking switch 14 are respectively turned off, a high voltage of a plus 50V brought by turning off the current breaking switch 14 is distributed to each FET connected in series with the wire E-E', F-F', and G-G'. Consequently, only a low voltage which is determined by a resistance value of the resistance element r is applied between terminals of each impedance circuit (CR parallel circuit) of the second dummy load 13 making up of an equivalent circuit of the monitor circuit.

That is, when a solid state switch which is turned on with a negative voltage, for example, a P-channel MOSFET, is used and interposed in each wire except for the wire on the lowest bottom, a positive and negative voltage is inversely operated compared with the first and second embodiments. When the current breaking switch 14 is turned off, FETs interposed in wires on the side of a higher electric voltage than that of the current breaking switch 14 are turned off. Consequently, a high voltage is not applied to the second dummy load 13 making up of an equivalent circuit of the monitor circuit as seen in a same operation in the first and second embodiments. Incidentally, in the third embodiment in which a P-channel FET is used, a diode can be connected in parallel with the CR parallel circuit of the second dummy load 13, similar to the second embodiment in FIG.4.

According to the embodiments of the present invention, in a battery pack provided by a series circuit of a plurality of batteries, when a current breaking switch interposed in series between optional batteries for the purpose of safeguard is turned off, a high voltage generated across both terminals of the current breaking switch due to a movement of an electric potential point is distributed to a solid state switch which is interposed in a wire used for detecting a battery voltage and which is turned off after turning off the current breaking switch. Therefore, a high voltage is not generated between input terminals of the monitor circuit when the current breaking switch is turned off.

Consequently, a risk of destroying each element of the monitor circuit with a high voltage is reduced. As a result, as a risk of blowing a fuse which prevents a failure from having a secondary ripple effect is also reduced, the possibility of exchanging fuses for a maintenance reason can be minimized. As the monitor circuit is not required to withstand a high voltage, intervals of wiring pattern on a print circuit board can be narrowed. As a result, downsizing for the monitor circuit with better prices can be achieved. Further, as it is not required to divide the monitor circuit into plural circuits on account of resisting a high voltage or the like, a print circuit board is simplified and further cost reduction can be achieved.

### [Effect of the Present Embodiments Comparing with Comparison Example]

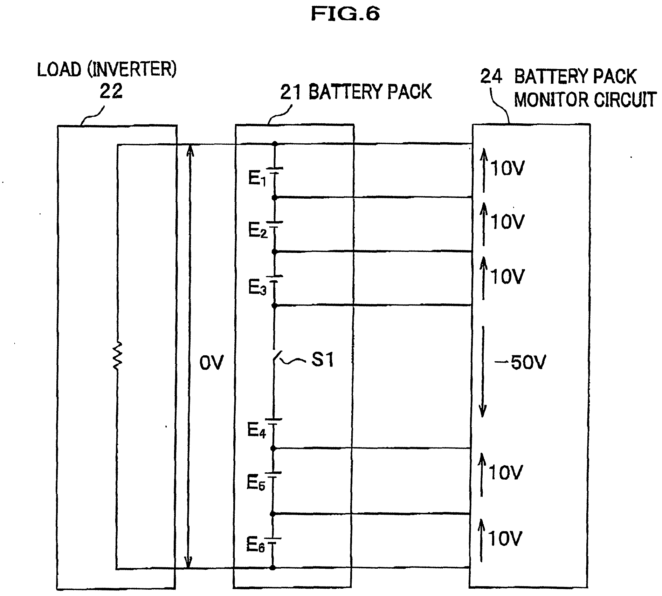

The power supply circuit shown from the first embodiment to the third embodiment is explained by comparing with a comparison example. FIG.6 is a circuit diagram showing a power supply circuit including a conventional monitor circuit. Six sets of batteries E1 to E6 connected in series provide a battery pack 21. A current breaking switch S1 is interposed in series between the batteries E3 and E4. A voltage of the battery pack 21 is provided for a load 22 such as an inverter or the like, further, a voltage between terminals of each battery E1 to E6 is monitored by a battery pack monitor circuit 24.

When the current breaking switch S1 is turned off for a maintenance reason or the like, an electric potential point is moved and a potential difference of a minus 50V is generated between input terminals of the battery pack monitor circuit 24 therebetween the current breaking switch S1 is interposed. However, as shown in each embodiment, if the solid state switch which is operated on a positive voltage is interposed in each wire except for the wire on the top and each solid state switch is turned on with a signal from a wire adjoining on the side of a high electric potential, there is no risk of generating a high voltage with reversed polarity between input terminals of the battery pack monitor circuit 24 therebetween the current breaking switch S1 is interposed at a time of turning off the current breaking switch S1.

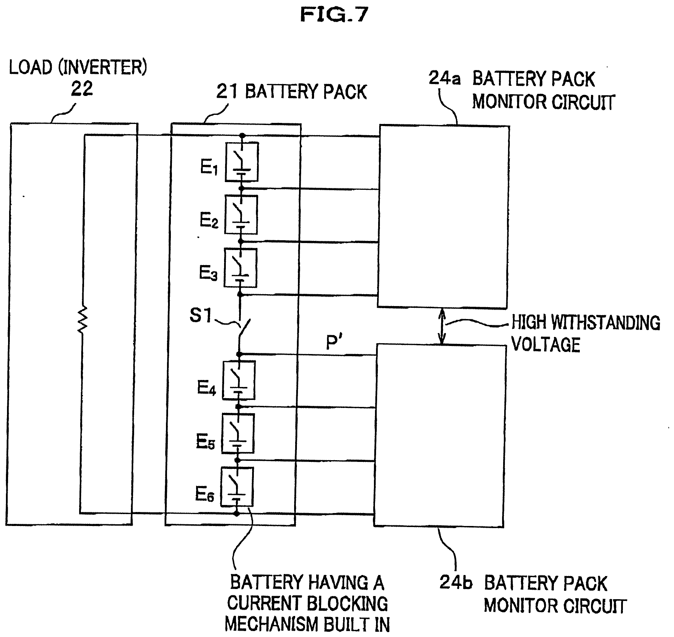

Then, FIG.7 is a block diagram showing a configuration of a power supply circuit in an embodiment wherein a monitor circuit is separated in two. That is, a voltage of each battery E1 to E6 providing the battery pack 21 is detected, a piece of a wire P' which is not found in the battery pack 21 in FIG.6 is added. As shown in FIG. 7, if wires are taken out from both terminals of the current breaking switch S1, two battery pack monitor circuit 24a and 24b are provided. Consequently, a high voltage of a minus 50V or the like is not applied between input terminals of each battery pack monitor circuit 24a and 24b. However, as a high voltage is applied between the battery pack monitor circuit 24a and the battery pack monitor circuit 24b, intervals of patterns on a print circuit board are required to widen in order to withstand a high voltage between the battery pack monitor circuit 24a and the battery pack monitor circuit 24b. On the other hand, under a configuration of each embodiment, there is no risk of generating a high voltage with reversed polarity between input terminals of the battery pack monitor circuit 24 therebetween the current breaking switch S1 is interposed, and it is not necessary to add a wire and divide a monitor in two.

When each of batteries E1 to E6 has a current blocking mechanism built-in, a high voltage with reversed polarity is generated on a wire connected with a battery wherein a current is cut off, and a high voltage of a minus 50V or the like is applied between input terminals of each the battery pack monitor circuit 24a and 24b. In this case, a high voltage applied between input terminals may be prevented if a wire drawn from a junction point connected with a switch part and a main part of a battery is added in the battery and a monitor circuit separated for every battery is connected with each battery. However, it is difficult to add the wire like this due to a structural reason of the battery, and the separation of monitor circuits leads to an increase in the number of circuit elements and an increase in size of a print circuit board. On the other hand, the configurations of the respective embodiments eliminate a risk of generating a high voltage with reversed polarity between input terminals of the battery pack monitor circuit 24 even if the current blocking mechanism of each battery is operated. It is unnecessary to add the wire and separate a monitor circuit per battery.

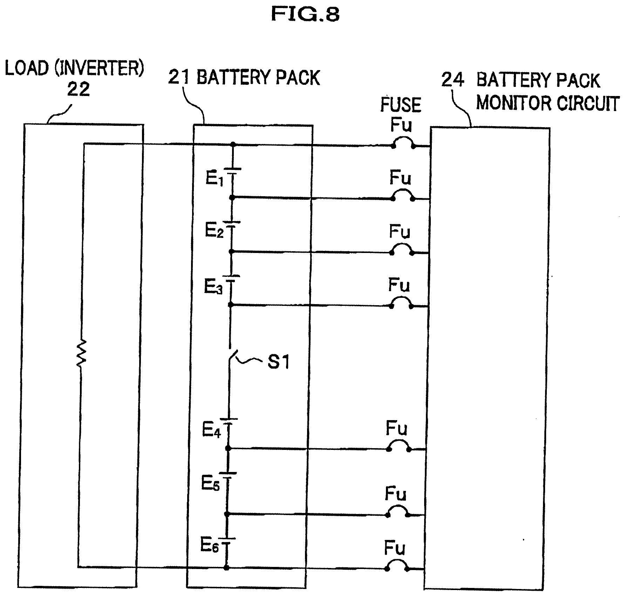

FIG.8 is a block diagram showing a configuration of a power supply circuit wherein a fuse or an insulated switch for drive is interposed in each wire between a monitor circuit and each battery providing a battery pack. That is, as shown in FIG. 8, if a fuse Fu is interposed in a wire for detecting a voltage of each of batteries E1 to E6, a large amount of currents generated by applying a high voltage between input terminals of a monitor circuit for a battery is cut off by the fuse Fu, and a secondary failure which has a ripple effect which can stretch across an other part of a circuit can be prevented. This fuse can be interposed in the wires for detecting each voltage in the first embodiment in FIG.2, in the second embodiment in FIG.4, and in the third embodiment in FIG. 5. Incidentally, an arc blow-out type of fuse needs to be used. An insulating switch for drive such as a photo MOS relay and the like can be used instead of the fuse Fu. However, the monitor circuit for a battery is required to be designed not to suffer a failure brought by a high voltage during a period of time when a fuse is blown after a high voltage is applied or when a photo MOS relay is turned off after a high voltage is applied. When a fuse is used, the task of replacing a blown fuse with a new one is involved.

## Claims

1. A voltage monitoring circuit for a storage unit including:
N electric storage cells connected in series, each including a given number of electric storage elements; and
a current breaking switch (3,14) interposed between at least a pair of adjacent electric storage cells of the N electric storage cells,
wherein a side of a lower electric potential of the N electric storage cells is connected via an electric load (2) with a side of a higher electric potential of the N electric storage cells which are connected in series,
wherein the voltage monitoring circuit comprises:
a monitor circuit (4) adapted to detect a voltage of each of N resistance elements connected in series;
wherein N+1 wires (P1, P2, P3, P4, P5) connect each terminal of the N resistance elements connected in series with a corresponding terminal of one of the N electric storage cells connected in series; and
N switching elements (5a, 5b, 5c, 5d), wherein each switching element is connected in series with one of N wires (P1, P2, P3, P4 or P2, P3, P4, P5) that are selected from the N+1 wires (P1, P2, P3, P4, P5) by skipping the wire with the maximum electric potential or the wire with the minimum electric potential of the N+1 wires (P1, P2, P3, P4, P5),
wherein one switching element of the N switching elements (5a, 5b, 5c, 5d) is adapted to be switched on according to the electric potential between a corresponding resistance element and another switching element, which another switching element is connected in series with a wire which is adjacent to the one switching element of the N switching elements (5a, 5b, 5c, 5d).

2. The voltage monitor circuit according to claim 1,
wherein each resistance element is connected in parallel with a diode in which an anode is placed on a side of a low electric potential and a cathode is placed on a side of a high electric potential.

3. The voltage monitor circuit according to claim 1 or 2,
wherein each switching element (5a, 5b, 5c, 5d) is a solid state switch which is turned on in response to a positive voltage, and
wherein each solid state switch (5a, 5b, 5c, 5d) is interposed in series in one of the N+1 wires (P1, P2, P3, P4, P5) except for the wire with the maximum electric potential and is turned on in response to an electric potential of a wire adjoining on a side of a high electric potential.

4. The voltage monitor circuit according to claim 1 or 2,
wherein each switching element (5a, 5b, 5c, 5d) is a solid state switch which is turned on in response to a negative voltage, and
wherein each solid state switch (5a, 5b, 5c, 5d) is interposed in series in one of the N+1 wires (P1, P2, P3, P4, P5) except for the wire with the minimum electric potential and is turned on in response to an electric potential of a wire adjoining on a side of a low electric potential.

## Patentansprüche

1. Spannungswächterschaltung für eine Speichereinheit, die aufweist:
N elektrische Speicherzellen, die in Reihe verbunden sind, von denen eine jede eine bestimmten Anzahl von elektrischen Speicherelementen aufweist; und
einen Stromunterbrechungsschalter (3, 14), der zwischen wenigstens einem Paar von benachbarten elektrischen Speicherzellen der N elektrischen Speicherzellen angeordnet ist,
wobei eine Seite eines niedrigeren elektrischen Potenzials der N elektrischen Speicherzellen über eine elektrische Last (2) mit einer Seite eines höheren elektrischen Potenzials der in Reihe verbundenen elektrischen N Speicherzellen verbunden ist,
wobei die Spannungswächterschaltung aufweist:
eine Überwachungsschaltung (4), die dazu ausgelegt ist, eine Spannung von einem jeden der in Reihe verbundenen N Widerstandselemente zu erfassen;
wobei N + 1 Drähte (P1, P2, P3, P4, P5) einen jeden Anschluss von den in Reihe verbundenen N Widerstandselementen mit einem entsprechenden Anschluss von einer der in Reihe verbundenen N elektrischen Speicherzellen verbinden; und
N Schalterelemente (5a, 5b, 5c, 5d), wobei ein jedes der Schalterelemente in Reihe mit einem der N Drähte (P1, P2, P3, P4 oder P2, P3, P4, P5) verbunden ist, die ausgewählt sind aus den N + 1 Drähten (P1, P2, P3, P4, P5), indem der Draht mit dem maximalen elektrischen Potenzial oder der Draht mit dem kleinsten elektrischen Potenzial der N + 1 Drähte (P1, P2, P3, P4, P5) übersprungen wird,
wobei ein Schalterelement der N Schalterelemente (5a, 5b, 5c, 5d) dazu ausgelegt ist, gemäß dem elektrischen Potenzial zwischen einem entsprechenden Widerstandselement und einem anderen Schalterelement geschalten zu werden, wobei das andere Schalterelement in Reihe mit einem Draht verbunden ist, der benachbart zu einem Schalterelement der N Schalterelemente (5a, 5b, 5c, 5d) ist.

2. Spannungswächterschaltung nach Anspruch 1,
wobei ein jedes Widerstandselement parallel mit einer Diode verbunden ist, bei der eine Anode an einer Seite eines niedrigen elektrischen Potenzials angeordnet ist und eine Kathode an einer Seite eines hohen elektrischen Potenzials angeordnet ist.

3. Spannungswächterschaltung nach Anspruch 1 oder 2,
wobei ein jedes Schalterelement (5a, 5b, 5c, 5d) ein Halbleiterschalter ist, der in Reaktion auf eine positive Spannung aktiviert wird, und
wobei eine jede von den Halbleiterschaltern (5a, 5b, 5c, 5d) in Reihe bei einem der N + 1 Drähte (P1, P2, P3, P4, P5) dazwischen angeordnet ist, mit Ausnahme bei dem Draht mit dem maximalen elektrischen Potenzial, und in Reaktion auf ein elektrisches Potenzial eines Drahts aktiviert wird, der an eine Seite mit hohem elektrischen Potenzial angrenzt.

4. Spannungswächterschaltung nach Anspruch 1 oder 2,
wobei ein jedes Schalterelement (5a, 5b, 5c, 5d) ein Halbleiterschalter ist, der in Reaktion auf eine negative Spannung aktiviert wird, und
wobei ein jeder Halbleiterschalter (5a, 5b, 5c, 5d) in Reihe bei einem von den N + 1 Drähten (P1, P2, P3, P4, P5) dazwischen angeordnet ist, mit Ausnahme des Drahts mit dem kleinsten elektrischen Potenzial, und in Reaktion auf ein elektrisches Potenzial eines Drahts aktiviert wird, der an eine Seite eines niedrigen elektrischen Potenzials angrenzt.

## Revendications

1. Circuit de surveillance de tension destiné à une unité d'accumulation, comportant :
N accumulateurs électriques connectés en série, comportant chacun un nombre donné d'éléments d'accumulation d'énergie électrique ; et
un interrupteur coupe-circuit (3, 14) intercalé entre au moins deux accumulateurs électriques adjacents des N accumulateurs électriques,
dans lequel un côté à potentiel électrique plus bas des N accumulateurs électriques est connecté par l'intermédiaire d'une charge électrique (2) à un côté à potentiel électrique plus haut des N accumulateurs électriques qui sont connectées en série,
dans lequel le circuit de surveillance de tension comprend :
un circuit de surveillance (4) conçu pour détecter une tension de chacun de N éléments résistifs connectés en série ;
dans lequel N + 1 fils (P1, P2, P3, P4, P5) connectent chaque borne des N éléments résistifs connectés en série à une borne correspondante de l'un des N accumulateurs électriques connectés en série ; et
N éléments de commutation (5a, 5b, 5c, 5d), dans lequel chaque élément de commutation est connecté en série à l'un de N fils (P1, P2, P3, P4 ou P2, P3, P4, P5) qui sont choisis parmi les N + 1 fils (P1, P2, P3, P4, P5) par saut du fil ayant le potentiel électrique maximum ou du fil ayant le potentiel électrique minimum parmi les N + 1 fils (P1, P2, P3, P4, P5),
dans lequel un élément de commutation des N éléments de commutation (5a, 5b, 5c, 5d) est conçu pour être mis à l'état passant en fonction du potentiel électrique entre un élément résistif correspondant et un autre élément de commutation, lequel autre élément de commutation est connecté en série à un fil qui est adjacent audit un élément de commutation des N éléments de commutation (5a, 5b, 5c, 5d).

2. Circuit de surveillance de tension selon la revendication 1,
dans lequel chaque élément résistif est connecté en parallèle à une diode dans laquelle une anode est placée d'un côté à potentiel électrique bas et une cathode est placée d'un côté à potentiel électrique haut.

3. Circuit de surveillance de tension selon la revendication 1 ou 2,
dans lequel chaque élément de commutation (5a, 5b, 5c, 5d) est un interrupteur à semi-conducteurs qui est mis à l'état passant en réponse à une tension positive, et
dans lequel chaque interrupteur à semi-conducteurs (5a, 5b, 5c, 5d) est intercalé en série sur l'un des N + 1 fils (P1, P2, P3, P4, P5), à l'exception du fil ayant le potentiel électrique maximum et est mis à l'état passant en réponse à un potentiel électrique de fil contigu à un côté à potentiel électrique haut.

4. Circuit de surveillance de tension selon la revendication 1 ou 2,
dans lequel chaque élément de commutation (5a, 5b, 5c, 5d) est un interrupteur à semi-conducteurs qui est mis à l'état passant en réponse à une tension négative, et
dans lequel chaque interrupteur à semi-conducteurs (5a, 5b, 5c, 5d) est intercalé en série sur l'un des N + 1 fils (P1, P2, P3, P4, P5), à l'exception du fil ayant le potentiel électrique minimum et est mis à l'état passant en réponse à un potentiel électrique de fil contigu à un côté à potentiel électrique bas.
